# EUROPEAN PATENT APPLICATION

(11) **EP 2 636 521 A1**
(43) Date of publication of application: **11.09.2013**
(21) Application number: 11838074.0
(22) Date of filing: 02.11.2011
(51) Int. Cl.: B32B 9/00, C23C 14/06, C23C 16/30

(54) **GAS-BARRIER LAMINATE FILM**

(30) Priority: 04.11.2010 JP 2010247513
(71) Applicant: Mitsubishi Plastics, Inc., Tokyo 100-8252 (JP)
(72) Inventor: YAMAUCHI, Koji, Ushiku-shi Ibaraki 300-1201 (JP); YOSHIDA, Shigenobu, Ushiku-shi Ibaraki 300-1201 (JP); HACHISUKA, Tooru, Ushiku-shi Ibaraki 300-1201 (JP); KIMURA, Shigeto, Ushiku-shi Ibaraki 300-1201 (JP)
(74) Representative: Ter Meer Steinmeister & Partner
(86) International application number: PCT/JP2011/075339
(87) International publication number: WO 2012/060424

(57) **Abstract**

Provided are a gas-barrier laminate film which shows good productivity, has high transparency, exhibits high-level gas-barrier properties and has excellent adhesion strength between the constituent layers therein, and which curls little; and a method for producing the film. The gas-barrier laminate film has, on at least one surface of a substrate film thereof, an inorganic thin layer formed by a vacuum vapor deposition, an inorganic thin layer formed by a chemical vapor deposition, and an inorganic thin layer formed by a vacuum vapor deposition in that order thereon, wherein the thickness of the inorganic thin layer formed by vacuum vapor deposition is from 0.1 nm to 500 nm, and the carbon content in the inorganic thin layer formed by chemical vapor deposition is from 0.5 at% to less than 20 at%, and the thickness of the layer is less than 20 nm.

## Description

### Technical Field

The present invention relates to a gas-barrier laminate film mainly used for wrapping materials for foods, medicines and others, for packaging materials for electronic devices and others, and also for materials for electronic papers, solar cells and others, and to a method for producing the film. More precisely, the invention relates to a gas-barrier laminate film having a silicon oxide layer excellent in gas-barrier properties, and to a method for producing the film.

### Background Art

Gas-barrier films are used as wrapping materials for foods, medicines and others for the purpose of preventing the effect of oxygen, water vapor and others that may cause change in the quality of the contents, or are used as packaging materials for electronic devices and others and also as materials for electronic papers and solar cells for the purpose of preventing liquid-crystal display panels or EL display panels and also the devices formed in electronic papers, solar cells and others from being deteriorated through exposure to oxygen or water vapor. Recently, gas-barrier films are often used in the part where glass or the like has heretofore been used, for the reason of making the part have flexibility and impact resistance.
In general, the gas-barrier film of the type comprises a substrate of a plastic film, and a gas barrier layer formed on one or both surfaces of the film. The gas-barrier film may be formed by various methods of a chemical vapor deposition (CVD) method, a physical vapor deposition (PVD) method or the like. According to any of those methods, the conventional gas-barrier film produced could have only an oxygen transmission rate (OTR) of 2 cc/m²/day or so or a water vapor transmission rate (WVTR) of 2 g/m²/day or so; and in applications that require a higher gas-barrier level, the film is still unsatisfactory.

Regarding the gas-barrier film as above, PTL 1 discloses a transparent gas-barrier material having a laminate configuration that comprises a first layer of silicon oxide alone and a second layer of silicon oxide with from 5 to 40 at.% of carbon, in which the layers are formed sequentially by a PVD method or a plasma activation vapor deposition method of vacuum evaporation, sputtering, ion plating or the like. PTL 2 discloses a gas-barrier film having, on one or both surfaces of the substrate thereof, a silicon oxide layer formed by a plasma CVD method, wherein the silicon oxide layer has a composition ratio of such that the number of O atoms is from 170 to 200 and the number of C atoms 30 or less relative to the number of Si atoms, 100. Further, PTL 3 discloses a gas barrier film having a plastic film, and as formed on at least one surface of the plastic film, a thin layer of a composition mainly comprising an oxide, wherein the carbon content of the thin layer is from 0.1 to 40 mol%. Still further, PTL 4 discloses a barrier film having a barrier layer of a silicon oxide layer (SiOx) as laminated on one or both surfaces of the plastic substrate thereof, wherein the barrier layer is formed of at least two silicon oxide layers, the thickness of one silicon oxide layer is from 10 nm to 50 nm, the thickness of the barrier layer comprises at least two silicon oxide layers is from 20 nm to 200 nm, and the proportion of the carbon atoms in the barrier layer is 10 at.% or less.

### Citation List

### Patent Literature

PTL 1: Japanese Patent 3319164
PTL 2: JP-A 2006-96046
PTL 3: JP-A 6-210790
PTL 4: JP-A 2009-101548

### Summary

### Technical Problem

The gas-barrier material described in PTL 1 is problematic in that, when the thickness of the second layer of silicon oxide that has a carbon content of from 5 to 40 at. % is actually increased to such a degree that the layer could fully exhibit the flexibility of the barrier layer, then the material colors greatly. In addition, the second layer of silicon dioxide having such a carbon content is poorly adhesive as the surface energy thereof is low, and therefore, in case where the thickness thereof is not increased in some degree, the layer would delaminate. On the other hand, for forming the second layer of carbon-containing silicon oxide, preferred is a plasma CVD method; however, the plasma CVD method is problematic in that, since the film formation rate thereof is lower than that of a vacuum evaporation method, the film formation speed in the plasma CVD method must be lowered for forming such a thick layer and the productivity of the method is therefore poor.
In the gas-barrier film described in PTL 2, the carbon-containing silicon oxide layer itself, which is formed by a plasma CVD method, is mainly in charge of the gas-barrier properties of the film, and therefore, in order that the film could exhibit sufficient barrier properties, the layer must be thick in some degree, which, however, is problematic in point of coloration and productivity.
Further, also in the gas-barrier film described in PTL 3, the thin layer of a composition mainly comprising a carbon-containing oxide is in charge of the gas-barrier properties of the film, and therefore, in fact, in order that the film could fully exhibit the barrier properties, the layer must be thick in some degree, which, however, is also problematic in point of coloration and productivity.
Further, in the gas-barrier film described in PTL 4, the layers of the same type formed by a plasma CVD method are laminated to form a barrier layer having a low carbon content; however, as compared with that in a vacuum evaporation method, the film formation rate in the plasma CVD method is significantly low and, in addition, in order that the film could in fact exhibit sufficient barrier properties, the layer must also be thick in some degree and is therefore also problematic in point of the productivity.

The subject matter of the present invention is to solve the above-mentioned problems with the conventional technology as above, and is to provide a gas-barrier laminate film which shows good productivity, has high transparency, exhibits high-level gas-barrier properties and has excellent adhesion strength between the constituent layers therein, and which curls little, and to provide a method for producing the film. Solution to Problem

The present invention relates to the following:
(1) A gas-barrier laminate film having, on at least one surface of the substrate film thereof, an inorganic thin layer formed by a vacuum vapor deposition (hereinafter this may be referred to as "PVD"), an inorganic thin layer formed by a chemical vapor deposition (hereinafter this may be referred to as "CVD"), and an inorganic thin layer formed by a vacuum vapor deposition (PVD) in that order thereon, wherein the thickness of the inorganic thin layer formed by vacuum vapor deposition (PVD) is from 0.1 nm to 500 nm, and the carbon content in the inorganic thin layer formed by chemical vapor deposition (CVD) is from 0.5 at.% to less than 20 at.%, and the thickness of the layer is less than 20 nm; and
(2) A method for producing the gas-barrier laminate film of the above (1), wherein the inorganic thin layer is formed by vacuum vapor deposition (PVD) under a reduced pressure of from 10⁻⁴ Pa to 10⁻² Pa and the inorganic thin layer is formed by chemical vapor deposition (CVD) under a reduced pressure of from 10⁻² Pa to 10 Pa, and the substrate film transportation velocity is 100 m/min or more.

### Advantageous Effects of Invention

The present invention provides a laminate film which shows good productivity, has high transparency, exhibits high-level gas-barrier properties and has excellent adhesion strength between the constituent layers therein, and which curls little, and also provides a method for producing the film. Description of Embodiments

The present invention is described in detail hereinunder.

### <Gas-Barrier Laminate Film>

The gas-barrier laminate film of the present invention has, on at least one surface of the substrate film thereof, an inorganic thin layer formed by PVD (hereinafter this may be referred to as "PVD inorganic thin layer (1)"), an inorganic thin layer formed by CVD (hereinafter this may be referred to as "CVD inorganic thin layer"), and an inorganic thin layer formed by PVD (hereinafter this may be referred to as "PVD inorganic thin layer (2)") in that order thereon.

### [Substrate Film]

The substrate film of the gas-barrier laminate film of the present invention is preferably a transparent polymer film, and from this viewpoint, more preferred is one formed of a thermoplastic polymer film. Not specifically defined, the material of the substrate film may be any resin capable of being used for ordinary wrapping materials or other materials for electronic papers and solar cells. Concretely, there are mentioned polyolefins, cyclic polyolefins and the like amorphous polyolefins such as homopolymers or copolymers of ethylene, propylene, butene, etc.; polyesters such as polyethylene terephthalate, polyethylene 2,6-naphthalate, etc.; polyamides such as nylon 6, nylon 66, nylon 12, copolymer nylon, etc.; as well as polyvinyl alcohols, partially hydrolyzed products of ethylene-vinyl acetate copolymer (EVOH), polyimides, polyether imides, polysulfones, polyether sulfones, polyether ether ketones, polycarbonates, polyvinyl butyrals, polyarylates, fluororesins, acylate resins, biodegradable resins, etc. Of those, polyesters, polyamides, polyolefins and biodegradable resins are preferred from the viewpoint of the film strength and the cost.
The substrate film may contain any known additive, for example, antistatic agent, light cutoff agent, UV absorbent, plasticizer, lubricant, filler, colorant, stabilizer, release agent, crosslinking agent, blocking inhibitor, antioxidant, etc.

The thermoplastic polymer film for the substrate film may be formed of the material mentioned above, and in case where the film is used as the substrate, it may be an unstretched one or a stretched one. The film may be laminated with any other plastic substrate. The substrate film of the type can be produced according to any known method. For example, a starting resin is melted in an extruder and extruded out through a ring die or a T die, and then rapidly cooled to give a substantially amorphous and un-oriented, unstretched film. The unstretched film may be stretched according to a known method of monoaxial stretching, tenter-assisted successive biaxial stretching, tenter-assisted simultaneous biaxial stretching, tubular simultaneous biaxial stretching of the like, in the film flow (longitudinal) direction or in the direction (lateral direction) vertical to the film flow direction, thereby giving a film that has been at least monoaxially stretched.

The thickness of the substrate film of the present invention may be selected generally from a range of from 5 to 500 µm, preferably from 10 to 200 µm, from the viewpoint of the mechanical strength, the flexibility and the transparency thereof and in accordance with the use thereof as the substrate of the gas-barrier laminate film of the present invention, and the substrate film in the present invention includes thick sheet-like films. The width and the length of the film are not specifically defined, and may be suitably selected in accordance with the use thereof.

### [Inorganic Thin Layer Formed by Vacuum Vapor Deposition (PVD)]

The gas-barrier laminate film of the present invention has a PVD inorganic thin layer (1), a CVD inorganic thin layer and a PVD inorganic thin layer (2) as formed in that order on at least one surface of the above-mentioned substrate film. The inorganic substance to constitute the PVD inorganic thin layers that are to be arranged as the upper and lower layers of the CVD inorganic thin layer includes silicon, aluminium, magnesium, zinc, tin, nickel, titanium, carbon and the like, as well as oxides, carbides and nitrides thereof, and mixtures thereof. From the viewpoint of the gas-barrier properties, preferred are silicon oxide, aluminium oxide, carbon (for example, substance mainly comprising carbon, such as diamond-like carbon, etc.). Especially preferred are silicon oxide and aluminium oxide as stably securing high-level gas-barrier properties. One alone or two or more different types of the above-mentioned inorganic substances may be used here either singly or as combined.

For forming the PVD inorganic thin layers (1) and (2) on the substrate film, preferred is a vacuum vapor deposition method from the viewpoint of producing a uniform thin layer having high-level gas-barrier properties.
Regarding the thickness of each of the PVD inorganic thin layers (1) and (2), the lower limit thereof is generally 0.1 nm but is preferably 0.5 nm, more preferably 1 nm, even more preferably 10 nm, and the upper limit thereof is generally 500 nm, but is preferably 100 nm, more preferably 50 nm. The thickness of the PVD inorganic thin layer is preferably from 0.1 to 500 nm, more preferably from 10 nm to 500 nm, even more preferably from 10 nm to 100 nm, still more preferably from 10 nm to 50 nm, from the viewpoint of the gas-barrier properties and the film productivity. The thickness of the PVD inorganic thin layer may be measured with fluorescence X-ray, and concretely, the thickness may be measured according to the method to be mentioned hereinunder.
The PVD inorganic thin layers (1) and (2) are formed under reduced pressure and preferably while the substrate film is moved, for forming dense and thin layers. The pressure under which the PVD inorganic thin layers (1) and (2) are formed is preferably from 1 × 10⁻⁷ to 1 Pa, more preferably from 1 × 10⁻⁶ to 1 × 10⁻¹ Pa, even more preferably from 1 × 10⁻⁴ to 1 × 10⁻² Pa, from the viewpoint of the vacuum degassing capability and the barrier properties. Within the above range, the PVD inorganic thin layers formed can secure sufficient gas-barrier properties and can be excellent in transparency, not being cracked or peeled.

### [Inorganic Thin Layer Formed by Chemical Vapor Deposition (CVD)]

In the present invention, a CVD inorganic thin layer is formed on the above-mentioned PVD inorganic thin layer (1). It is considered that the CVD inorganic thin layer could fill up the defects formed in the PVD inorganic thin layer to thereby enhance gas-barrier properties and the interlayer adhesiveness of the laminate film.
In the chemical vapor deposition method, the film formation speed must be increased to realize high productivity and evade any thermal damage to the film substrate, and therefore, preferred is a plasma CVD method. Thin layers to be formed by a plasma CVD method include thin layers of at least one selected from metals, metal oxides, metal nitrides and the like to be produced through plasma decomposition of organic substances.

In the present invention, the carbon content in the CVD inorganic thin layer, as measured through X-ray photoelectron spectroscopy (XPS), is less than 20 at. %, preferably less than 10 at.%, more preferably less than 5 at.%. Having the carbon content falling within the range, the surface energy of the inorganic thin layer can be large and the adhesiveness between the inorganic thin layers can be prevented from being worsened. Consequently, the bend-tolerance and the peeling resistance of the barrier film can be thereby enhanced.
Preferably, the carbon content in the CVD inorganic thin layer is 0.5 at.% or more, more preferably 1 at.% or more, even more preferably 2 at.% or more. The interlayer thus contains carbon though slightly, and therefore the barrier film can secure efficient stress relaxation therein and can be prevented from curling.
From the above-mentioned points, the carbon content in the CVD inorganic thin layer is preferably from 0.5 at.% to less than 20 at.%, more preferably from 0.5 at.% to less than 10 at.%, still more preferably from 0.5 at.% to less than 5 at.%, further more preferably from 1 at.% to less than 5 at.%, still further more preferably from 2 at.% to less than 5 at.%. Here, "at. %" means atomic %.

In the present invention, the method of attaining the above-mentioned carbon content as measured through X-ray photoelectron spectroscopy (XPS) is not specifically defined. For example, there are mentioned a method of attaining the range by selecting the starting material in CVD, a method of attaining the range by controlling the flow rate and the ratio of the starting material and the reaction gas (oxygen, nitrogen, etc.), a method of attaining the range by controlling the pressure and the electric power in film formation, etc.
A concrete method for measuring the carbon content through X-ray photoelectron spectroscopy (XPS) is described hereinunder.

As the CVD inorganic thin layer, herein employed is a thin layer containing at least one selected from metals, metal oxides and metal nitrides. From the viewpoint of the gas-barrier properties and the adhesiveness, preferred are metals, for example, silicon, titanium, diamond-like carbon (hereinafter referred to as "DLC") and the like, as well as alloys of two or more of such metals. As the metal oxides and metal nitrides, preferred here are oxides and nitrides of the above-mentioned metals and mixtures thereof, from the viewpoint of the gas-barrier properties and the adhesiveness. In the present invention, as the CVD inorganic thin layer, preferred are those formed of at least one selected from silicon oxide, silicon nitride, silicon oxynitride, titanium oxide and DLC, from the above-mentioned viewpoints. Also preferred are those produced through plasma decomposition of organic compounds.

As the starting material for formation of the CVD inorganic thin layer such as a silicon oxide layer or the like, employable here is any compound such as a silicon compound or the like that is in any state of vapor, liquid or solid at room temperature and under ordinary pressure. In case where the material is vapor, it may be introduced into the discharge space directly as it is, but in case where the material is liquid or solid, it may be vaporized before use according to a method of heating, bubbling, depressurization, ultrasonication or the like. As the case may be, the material may be diluted with a solvent, and as the solvent, usable here is an organic solvent such as methanol, ethanol, n-hexane or the like or a mixed solvent of these.

The silicon compound includes silane, tetramethoxysilane, tetramethoxysilane, tetra-n-propoxysilane, tetraisopropoxysilane, tetra-n-butoxysilane, tetra-t-butoxysilane, dimethyldimethoxysilane, dimethyldimethoxysilane, dimethyldimethoxysilane, diphenyldimethoxysilane, methyltrimethoxysilane, ethyltrimethoxysilane, phenyltrimethoxysilane, (3,3,3-trifluoropropyl)trimethoxysilane, hexamethyldisiloxane, bis(dimethylamino)dimethylsilane, bis(dimethylamino)methylvinylsilane, bis(ethylamine)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiyne, di-t-butylsilane,1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propyne, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethyldisiloxane, hexamethylcyclotetrasiloxane, M-Silicate 51, etc.

The titanium compound as the starting material to form the titanium oxide layer is an inorganic titanium compound or an organic titanium compound. The inorganic titanium compound includes titanium oxide, titanium chloride, etc. The organic titanium compound includes titanium alkoxides such as titanium tetra-butoxide, tetra-normal-butyl titanate, butyl titanate dimer, tetra(2-ethylhexyl) titanate, tetramethyl titanate, etc.; titanium chelates such as titanium lactate, titanium acetylacetonate, titanium tetra-acetylacetonate, polytitanium acetylacetonate, titanium octylene glycolate, titanium ethylacetoacetate, titanium triethanolaminate, etc.

The above-mentioned CVD inorganic thin layer is preferably comprises at least two layers for securing the effect of filling up the PVD inorganic thin layer, more preferably from 2 to 5 layers.
The thickness of the CVD inorganic thin layer is, as measured through cross-sectional TEM, less than 20 nm. Having the thickness falling within the range, the intermolecular force of the PVD inorganic thin layers could act effectively, therefore enhancing more the adhesiveness. In addition, the production speed in chemical vapor deposition can be increased up to the same level as that in vacuum evaporation deposition, and therefore, the production efficiency is increased and further, the production equipment can be down-sized and simplified, and consequently, low-cost barrier films can be provided. From the above-mentioned viewpoints, the thickness of the CVD inorganic thin layer is preferably less than 10 nm, more preferably less than 5 nm, even more preferably less than 3 nm.

The lower limit of the thickness of the CVD inorganic thin layer is, as the lowermost thickness thereof capable of expressing the effect of filling up the PVD inorganic thin layer, preferably 0.01 nm, more preferably 0.1 nm, even more preferably 0.5 nm. When the thickness falls within the above range, the adhesiveness and the gas-barrier properties of the laminate film are favorably good. From the above-mentioned viewpoints, the thickness of the CVD inorganic thin layer is preferably from 0.01 nm to less than 20 nm, more preferably from 0.1 nm to less than 20 nm, even more preferably from 0.1 nm to less than 10 nm, still more preferably from 0.1 nm to less than 5 nm, further more preferably from 0.1 nm to less than 3 nm.

Of the CVD inorganic thin layer and the PVD inorganic thin layer adjacent to each other in the present invention, the ratio of the thickness (CVD inorganic thin layer thickness/PVD inorganic thin layer thickness) is preferably from 0.0001 to 0.2, more preferably from 0.0005 to 0.1, even more preferably from 0.001 to 0.1. In case where the CVD inorganic thin layer thickness is smaller than the above-mentioned range relative to the PVD inorganic thin layer thickness, then the proportion of the CVD inorganic thin layer is extremely small relative to all the inorganic thin layers, and in such a case, the characteristics of the laminate film would be almost indistinguishable from those of a case of a PVD inorganic thin layer alone, or that is, the CVD inorganic thin layer could not almost exhibit the filling-up effect thereof and other effects of stress relaxation, etc. On the other hand, a case where the CVD inorganic thin layer thickness is larger than the above-mentioned case relative to the PVD inorganic thin layer thickness is also unfavorable. This is because the film formation rate according to the CVD method is extremely low as compared with that according to the PVD method, and therefore, in order that the PVD inorganic thin layer and the CVD inorganic thin layer are continuously formed in a roll-to-roll process, the substrate film transportation velocity must be lowered in accordance with the low film formation rate of the CVD inorganic thin layer, and as a result, the productivity would lower.

The surface roughness of the PVD inorganic thin layer (as measured through AFM) is preferably about 5 nm or less for barrier performance expression since the vapor-deposited particles could accumulate densely. In this case where the thickness of the CVD inorganic thin layer is controlled to be less than the above limit, then the open pores existing in the valley area between the deposited particles could be filled up and the mountain area of the deposited particles could be coated only extremely thinly (or in a state where the area is partly exposed out), and therefore the interlayer adhesiveness of the PVD inorganic thin layer could be further enhanced. In addition, when the thickness of the CVD inorganic thin layer is 0.1 nm or more, then the layer is effective for filling up the open pores in the lower layer of the PVD inorganic thin layer and is additionally effective for smoothing the lower layer and, as a result, when the upper layer of the PVD inorganic thin layer is formed by vapor deposition, then the surface diffusion of the deposited particles is bettered and therefore the particles can accumulate more densely to thereby further enhance the barrier properties of the laminate film.
The thickness of the CVD inorganic thin layer can be measured through cross-sectional TEM using a transmission electron microscope (TEM), and concretely according to the method to be mentioned hereinunder.

In the present invention, preferably, the CVD inorganic thin layer is formed in a reduced-pressure atmosphere of 10 Pa or less and at a substrate film transportation velocity of 100 m/min or more.
Specifically, the pressure under which the thin layer is formed by a chemical vapor deposition (CVD) is preferably a reduced pressure for forming a dense thin layer; and from the viewpoint of the film formation speed and the barrier properties of the formed film, the pressure is preferably 10 Pa or less, more preferably within a range of from 1 × 10⁻² to 10 Pa, even more preferably from 1 × 10⁻¹ to 1 Pa. The CVD inorganic thin layer may be crosslinked through irradiation with electron beams for enhancing the waterproofness and the durability thereof.
The substrate film transportation velocity is preferably 100 m/min or more from the viewpoint of enhancing the productivity, more preferably 200 m/min or more. The upper limit of the transportation velocity is not specifically defined, but is preferably 1000 m/min or less from the viewpoint of the stability of film conveyance.

The method for forming the CVD inorganic thin layer is described. The above-mentioned starting material compound is vaporized, and the resulting gas is introduced into a vacuum chamber, and plasmatized therein by the use of a low-temperature plasma generation apparatus for direct current (DC) plasma, low-frequency plasma, radiofrequency (RF) plasma, pulse wave plasma, tripolar structure plasma, microwave plasma, downstream plasma, columnar plasma, plasma-assisted epitaxy, etc. From the viewpoint of the plasma stability, more preferred is a radiofrequency (RF) plasma apparatus.
Apart from the plasma CVD method, also employable here are any known methods of a thermal CVD method, a cat-CVD method (catalytic chemical vapor deposition), an optical CVD method, an MOCVD method, etc. Of those, preferred are a thermal CVD method and a cat-CVD method as excellent in mass productivity and quality in film formation.

The gas-barrier laminate film of the present invention has a laminate structure of the PVD inorganic thin layer (1), the CVD inorganic thin layer and the PVD inorganic thin layer (2) as laminated in that order, as described below. In this, the CVD inorganic thin layer itself does not almost contribute toward the gas barrier properties of the laminate film, but exhibits an effect of filling up the lower PVD inorganic thin layer and an anchoring effect for the upper PVD inorganic thin layer; and accordingly, as compared with a case where a PVD inorganic thin layer is formed thick or a case where PVD inorganic thin layers or CVD inorganic thin layers are laminated, the laminate film of the present invention can have dramatically enhanced gas-barrier properties.

### [Layer Formation Method]

In the present invention, preferably, the PVD inorganic thin layer (1), the CVD inorganic thin layer and the PVD inorganic thin layer (2) mentioned above are formed continuously under reduced pressure, from the viewpoint of the gas barrier properties and the productivity of the laminate film. Also from the same viewpoints, in the present invention, it is desirable that all the constituent thin layers are formed in one and the same vacuum chamber preferably while the substrate film is transported, and in particular, it is desirable that the CVD inorganic thin layer is formed while the substrate film transportation velocity is kept at 100 m/min or more. Specifically, in the present invention, after the formation of each thin layer, the pressure in the vacuum chamber is not restored to around the atmospheric pressure to carry out the subsequent step after the chamber is again vacuated, but it is desirable that the layer formation is carried out continuously while kept in vacuum all the time in the process.

In the present invention, each layer is formed in one and the same vacuum chamber, or that is, all the PVD inorganic thin layers and the CVD inorganic thin layer are formed in one and the same vacuum chamber whereby the laminate film formed can express extremely good gas barrier properties. Though the principle is not clear, it may be considered that, when the formation of the PVD inorganic thin layer and the formation of the CVD inorganic thin layer are carried out in one and the same vacuum chamber, then the minor defects generated in the PVD inorganic thin layer (1) could be filled up uniformly and further, the gas barrier properties of the PVD thin layer (2) could be further enhanced.

In the present invention, after the PVD inorganic thin layer (1) has been formed, the CVD inorganic thin layer and the PVD inorganic thin layer (2) are formed, and in the process, the formation of the CVD inorganic thin layer and the formation of the PVD inorganic thin layer can be repeated further once or more. Specifically, in the present invention, it is desirable that one or more constitutive units of a CVD inorganic thin layer and a PVD inorganic thin layer are further formed on the structure of the PVD inorganic thin layer (1), the CVD inorganic thin layer and the PVD inorganic thin layer (2), from the viewpoint of quality stability, and more preferably, from 1 to 3 units of the additional layers are formed, even more preferably 1 or 2 units thereof are formed.
Also in the above case where the formation of the inorganic thin layers is repeated, it is desirable that the formation is attained continuously in one and the same apparatus under reduced pressure.
Specifically, in the present invention, the PVD inorganic thin layer (1) provides a uniform thin layer having high-level gas barrier properties. In addition, the formation of the CVD inorganic thin layer and the PVD inorganic thin layer (2) enhances the adhesiveness between the constitutive layers in the multilayer of the inorganic thin layers.

### [Anchor Coat Layer]

In the present invention, preferably, an anchor coat agent is applied between the substrate film and the PVD inorganic thin layer (1) to form an anchor coat layer therebetween, for enhancing the adhesiveness between the substrate film and the PVD inorganic thin layer (1). As the anchor coat agent, employable here are one or more selected from polyester resins, urethane resins, acrylic resins, nitrocellulose resins, silicone resins, vinyl alcohol resins, polyvinyl alcohol resins, ethylene/vinyl alcohol resins, vinyl-modified resins, isocyanate group-containing resins, carbodiimide resins, alkoxyl group-containing resins, epoxy resins, oxazoline group-containing resins, modified styrene resins, modified silicone resins, alkyl titanate resins, polyparaxylylene resins and the like, either singly or as combined from the viewpoint of the productivity.

The thickness of the anchor coat layer to be formed on the substrate film may be generally from 0.1 to 5000 nm, preferably from 1 to 2000 nm, more preferably from 1 to 1000 nm. Falling within the range, the anchor coat layer may have good lubricity and does not almost peel from the substrate film owing to the internal stress inside the anchor coat layer itself, and in addition, the layer can keep a uniform thickness and is excellent in the interlayer adhesiveness thereof.
In addition, for enhancing the coatability of the substrate film with the anchor coat agent and the adhesiveness thereof, the substrate film may be surface-treated through ordinary chemical treatment or discharge treatment prior to being coated with the anchor coat agent.

### [Protective Layer]

Also preferably, the gas-barrier laminate film of the present invention has a protective layer as the outermost layer on the side on which the above-mentioned thin layers are formed. The resin to form the protective layer may be any solvent-type or aqueous resin, concretely including polyester resins, urethane resins, acrylic resins, polyvinyl alcohol resins, ethylene/unsaturated carboxylic acid copolymer resins, ethylene/vinyl alcohol resins, vinyl-modified resins, nitrocellulose resins, silicone resins, isocyanate resins, epoxy resins, oxazoline group-containing resins, modified styrene resins, modified silicone resins, alkyl titanates and the like. One or more different types of those resins may be used for the layer either singly or as combined. As the protective layer, preferred is use of a layer formed by mixing at least one or more different types of inorganic particles selected from those of a silica sol, an alumina sol, a particular inorganic filler and a layered inorganic filler with at least one of the above-mentioned resins, or a layer of an inorganic fine particles-containing resin formed through polymerization of the starting material for the resin in the presence of the inorganic fine particles, for the purpose of enhancing the barrier properties, the abrasion resistance and the lubricity of the laminate film.

As the resin to form the protective layer, preferred are the above-mentioned aqueous resins from the viewpoint of enhancing the gas-barrier properties of the inorganic thin layers. As the aqueous resin, preferred are polyvinyl alcohol resins, ethylene/vinyl alcohol resins, or ethylene/unsaturated carboxylic acid copolymer resins.
In the present invention, the protective layer may be formed of one resin, but two or more different types of resins may be used for forming the protective layer.
Inorganic particles may be added to the protective layer for enhancing the barrier properties and the adhesiveness of the laminate film.
The inorganic particles for use in the present invention are not specifically defined. For example, usable here are any known ones of inorganic fillers, inorganic layered compounds, metal oxide sols, etc.

The thickness of the protective layer is preferably from 0.05 to 10 µm, more preferably from 0.1 to 3 µm from the viewpoint of the printability and the workability. As the method for forming the layer, any known coating method is employable suitably. For example, employable here is any coating method with a reverse roll coater, a gravure coater, a rod coater, an air doctor coater, a spray or a brush. If desired, the deposited film may be immersed in a resin liquid for protective layer. After coated, the film may be dried according to any known drying method or hot air drying, hot roll drying, heating drying, IR drying or the like at a temperature of from 80 to 200°C or so to thereby remove water through evaporation. Accordingly, a laminate film having a uniform coating layer can be obtained.

### [Configuration of Gas-Barrier Laminate Film]

The following embodiments are preferred for the gas-barrier laminate film of the present invention from the viewpoint of the gas-barrier properties and the adhesiveness thereof.
(1) Substrate film/AC/PVD inorganic thin layer/CVD inorganic thin layer/PVD inorganic thin layer
(2) Substrate film/AC/PVD inorganic thin layer/CVD inorganic thin layer/PVD inorganic thin layer/CVD inorganic thin layer/PVD inorganic thin layer
(3) Substrate film/AC/PVD inorganic thin layer/CVD inorganic thin layer/PVD inorganic thin layer/CVD inorganic thin layer/PVD inorganic thin layer/CVD inorganic thin layer/PVD inorganic thin layer
(4) Substrate film/AC/PVD inorganic thin layer/CVD inorganic thin layer/PVD inorganic thin layer/protective layer
(5) Substrate film/AC/PVD inorganic thin layer/CVD inorganic thin layer/PVD inorganic thin layer/CVD inorganic thin layer/PVD inorganic thin layer/protective layer
(6) Substrate film/AC/PVD inorganic thin layer/CVD inorganic thin layer/PVD inorganic thin layer/CVD inorganic thin layer/PVD inorganic thin layer/CVD inorganic thin layer/PVD inorganic thin layer/protective layer

(7) Substrate film/PVD inorganic thin layer/CVD inorganic thin layer/PVD inorganic thin layer
(8) Substrate film/PVD inorganic thin layer/CVD inorganic thin layer/PVD inorganic thin layer/CVD inorganic thin layer/PVD inorganic thin layer
(9) Substrate film/PVD inorganic thin layer/CVD inorganic thin layer/PVD inorganic thin layer/CVD inorganic thin layer/PVD inorganic thin layer/CVD inorganic thin layer/PVD inorganic thin layer
(10) Substrate film/PVD inorganic thin layer/CVD inorganic thin layer/PVD inorganic thin layer/protective layer
(11) Substrate film/PVD inorganic thin layer/CVD inorganic thin layer/PVD inorganic thin layer/CVD inorganic thin layer/PVD inorganic thin layer/protective layer
(12) Substrate film/PVD inorganic thin layer/CVD inorganic thin layer/PVD inorganic thin layer/CVD inorganic thin layer/PVD inorganic thin layer/CVD inorganic thin layer/PVD inorganic thin layer/protective layer

### (In the above embodiments, AC indicates an anchor coat layer.)

In the present invention, various other gas-barrier laminate films having any additional constitutive layer optionally laminated on the above-mentioned constitutive layers are usable depending on the intended use thereof.
In ordinary embodiments, gas-barrier laminate films additionally having a plastic film on the inorganic thin layer or the protective layer in the above are usable in various applications. The thickness of the plastic film is selected from a range of generally from 5 to 500 µm, preferably from 10 to 200 µm from the viewpoint of the mechanical strength, the flexibility, the transparency and others thereof as the substrate of laminate structures. The width and the length of the film are not specifically defined, and may be suitably selected in accordance with the use thereof. In using the barrier film for producing industrial products, the width and the length of the film are preferably longer from the viewpoint of the productivity and the cost advantage thereof in that long-size products can be produced and a large number of products can be produced in one process. Preferably, the width of the film is 0.6 m or more, more preferably 0.8 m or more, even more preferably 1.0 m or more; and the length of the film is preferably 1000 m or more, more preferably 3000 m or more, even more preferably 5000 m or more. In addition, for example, in case where a heat-sealable resin is provided on the surface of the inorganic thin layer or the protective layer, then the film can be heat-sealable and can be used for various containers. As the heat-sealable resin, there are exemplified various known resins such as polyethylene resins, polypropylene resins, ethylene/vinyl acetate copolymers, ionomer resins, acrylic resins, biodegradable resins, etc.

As other embodiments of the gas-barrier laminate film, there are mentioned those having a print layer on the coating surface of the inorganic thin layer or the protective layer and further having a heat-seal layer laminated thereon. The printing ink to form the print layer may be any of an aqueous or solvent-type resin-containing ink. Here, examples of the resin for use for the printing ink include acrylic resins, urethane resins, polyester resins, vinyl chloride resins, vinyl acetate copolymer resins, and mixtures thereof. Further, any known additive may be added to the printing ink, for example, antistatic agent, light cutoff agent, UV absorbent, plasticizer, lubricant, filler, colorant, stabilizer, release agent, defoaming agent, crosslinking agent, blocking inhibitor, antioxidant, etc.

The printing method for forming the print layer is not specifically defined, and any known printing method is employable here, for example, an offset printing method, a gravure printing method, a screen printing method, etc. For removing the solvent by drying after printing, employable is any known drying method of hot air drying, hot roll drying, IR drying or the like.
At least one layer of paper or plastic film may be laminated between the print layer and the heat-seal layer. As the plastic film, usable is the same one as that of the thermoplastic polymer film for the substrate layer for use in the gas-barrier laminate film of the present invention. Above all, from the viewpoint of securing sufficient laminate stiffness and strength, preferred are paper, polyester resins, polyamide resins, or biodegradable resins.

### <Method for Producing Gas-Barrier Laminate Film>

The production method for a gas-barrier laminate film of the present invention is a method for producing the above-mentioned gas-barrier laminate film, in which, preferably, the inorganic thin layer is formed by vacuum vapor deposition under a reduced pressure of from 10⁻⁴ Pa to 10⁻² Pa and the inorganic thin layer is formed by chemical vapor deposition (CVD) under a reduced pressure of from 10⁻² Pa to 10 Pa, and the substrate film transportation velocity is 100 m/min or more.
In the method, the gas-barrier laminate film, the pressure and the transportation velocity are as described above.

### <Description of Terms>

Unless otherwise specifically indicated in the specification, the expression of "from X to Y" (where X and Y each indicate an arbitrary number) means "X or more and Y or less".

### Examples

The present invention is described more concretely with reference to the following Examples; however, the present invention is not limited to the following Examples. The methods for evaluation of the film in the following Examples are as mentioned below.

### <Water Vapor Transmission Rate>

According to various conditions in JIS Z0222 "Moisture Transmission Test Method for Moistureproof Packaging Container" and JIS Z0208 "Test Method for Determination of Water Vapor Transmission Rate of Moistureproof Packaging Material (Cup method)", the film was evaluated as follows.
Two sheets of the gas-barrier laminate film having a moisture-permeable area of 10.0 cm × 10.0 cm square were prepared, and formed into a pouch by sealing up the four sides thereof while about 20 g of a moisture absorbent, anhydrous calcium chloride was kept put therein. The pouch was put in a constant-temperature constant-humidity chamber having a temperature of 40°C and a relative humidity of 90%, and at intervals of 48 hours or more, its weight was measured (0.1 mg unit) for 14 days as an indication of the term after which the weight increase could be nearly constant, and the water vapor transmission rate of the film was computed according to the following formula.
Water Vapor transmission Rate (g/m²/day) = (m/s)/t,
m : mass increase (g) between the last two measuring times in the test period,
s: moisture-permeable area (m²),
t: time (h)/24(h) between the last two measuring times in the test period.

### <Thickness of Inorganic thin Layer Formed by Vacuum Vapor Deposition (PVD)>

The thickness of the inorganic thin layer was measured with fluorescent X-ray. The method is one that utilizes the phenomenon of such that, when an atom is irradiated with an X-ray, then it radiates a fluorescent X-ray peculiar to the atom, in which, therefore, the number (amount) of the atoms can be known by measuring the radiated fluorescent X-ray intensity. Concretely, two thin layers each having a different known thickness are formed on a substrate film, and the intensity of the specific fluorescent X-ray radiated by each layer is measured, and a calibration curves are formed from the information data. The fluorescent X-ray intensity of the sample to be analyzed is measured in the same manner as above, and from the calibration curve, the thickness of the layer is estimated.

### <Thickness of Inorganic thin Layer Formed by Chemical Vapor Deposition (CVD)>

A sample is prepared according to an epoxy resin-embedded ultrathin section method, and analyzed with a JEOL's cross-section transmission electron microscope, TEM (JEM-1200EXII) under the condition of an acceleration voltage of 120 KV. The thickness of the CVD inorganic thin layers of 10 nm or less is difficult to accurately determine even in cross-section TEM. For such thin layers, therefore, relatively thick CVD inorganic thin layers of 20 nm or more that had been formed under the same film formation condition were analyzed through cross-section TEM, and the film formation rate per the unit running speed was computed from the data, and the thickness of the sample formed at the actual running speed in each Example was estimated from the thus-computed data.

### <Carbon Content in CVD Inorganic Thin Layer>

Using Thermofisher Scientific's XPS Analyzer, K-Alpha, the binding energy was measured by XPS (X-ray photoelectron spectroscopy). From the peak area corresponding to Si2P, C1S, N1S, O1S and others, the data were converted into elemental composition (at.%) through computation. The carbon content of the CVD inorganic thin layer was read in the part of the CVD inorganic thin layer of the XPS chart.

### Example 1

As the substrate film, used here was a biaxially-stretched polyethylene naphthalate film (Teijin DuPont's "Q51C12") having a width of 1.2 m, a length of 12000 m and a thickness of 12 µm. A mixture prepared by mixing an isocyanate compound (Nippon Polyurethane Industry's "Coronate L") and a saturated polyester (Toyobo's "Vylon 300", having a number-average molecular weight of 23000) in a ratio by mass of 1/1 was applied onto the corona-treated surface of the film and dried to form thereon an anchor coat layer having a thickness of 100 nm.
Next, using a vacuum evaporation apparatus, an SiOx vapor deposition layer (PVD layer) having a thickness of 40 nm was formed on the anchor coat layer by vacuum vapor deposition of SiO in vacuum of 2 × 10⁻³ Pa according to a high-frequency heating system. Next, using the same vacuum evaporation apparatus in which the pressure was not restored to atmospheric pressure, HMDSN (hexamethyldisilazane), nitrogen and Ar gas were introduced into the apparatus in a ratio by mol of 1/7/7, and then plasmatized therein in vacuum of 0.4 Pa, thereby forming a CVD inorganic thin layer (SiOCN (silicon oxycarbonitride)) (thickness 1 nm) on the inorganic thin layer. In forming the CVD inorganic thin layer, the substrate film transportation velocity was 250 m/min.

Next, in the same vacuum evaporation apparatus in which the pressure was not restored to atmospheric pressure, SiO was evaporated according to a high-frequency heating system in vacuum of 2 × 10⁻³ Pa, thereby forming an inorganic thin layer (SiOx) having a thickness of 40 nm on the CVD inorganic thin layer. Further, an urethane adhesive (prepared by mixing Toyo Morton's "AD900" and "CAT-RT85" in a ratio of 10/1.5) was applied onto the inorganic thin layer side of the thus-obtained film, and dried to thereby form thereon an adhesive resin layer having a thickness of about 3 µm. On the adhesive resin layer, an unstretched polypropylene film (Toyobo's Pyrene Film-CT P1146") having a thickness of 60 µm was laminated to give a laminate film. Thus obtained, the laminate film was evaluated as above. The results are shown in Table 1.

### Example 2

A laminate film was produced in the same manner as in Example 1 except that one more CVD inorganic thin layer and one more vacuum vapor deposition layer (PVD inorganic thin layer) were formed in that order and under the same condition as in Example 1. The obtained laminate film was evaluated in the same manner as above. The results are shown in Table 1.

### Example 3

A laminate film was produced in the same manner as in Example 1 except that the formation of the CVD inorganic thin layer was repeated two times under the same condition as in Example 1 to thereby make the CVD inorganic thin layer have a two-layer configuration. The obtained laminate film was evaluated in the same manner as above. The results are shown in Table 1.

### Example 4

A laminate film was produced in the same manner as in Example 1 except that the thickness of the CVD inorganic thin layer was changed to 4 nm at a film formation speed of 100 m/min. The obtained laminate film was evaluated in the same manner as above. The results are shown in Table 1.

### Example 5

A laminate film was produced in the same manner as in Example 4 except that the thickness of the CVD inorganic thin layer was changed to 8 nm by doubling the electric power in film formation. The obtained laminate film was evaluated in the same manner as above. The results are shown in Table 1.

### Example 6

A laminate film was produced in the same manner as in Example 5 except that the thickness of the CVD inorganic thin layer was changed to 17 nm with introducing HMDSN (hexamethyldisilazane), nitrogen and Ar gas in a ratio by mol of 1/1/1 and under a film formation pressure of 0.9 Pa. The obtained laminate film was evaluated in the same manner as above. The results are shown in Table 1.

### Example 7

A laminate film was produced in the same manner as in Example 1 except that the thickness of the CVD inorganic thin layer was changed to 0.1 nm by lowering the electric power in film formation. The obtained laminate film was evaluated in the same manner as above. The results are shown in Table 1.

### Example 8

A laminate film was produced in the same manner as in Example 1 except that the thickness of the PVD inorganic thin layer was changed to 25 nm and that of the CVD inorganic thin layer was to 0.1 nm by lowering the electric power in the vacuum vapor deposition and in CVD film formation. The obtained laminate film was evaluated in the same manner as above. The results are shown in Table 1.

### Comparative Example 1

A laminate film was produced in the same manner as in Example 1 except that the CVD inorganic thin layer was not formed and the additional vacuum vapor deposition layer was formed directly on the previous vacuum vapor deposition layer. The obtained laminate film was evaluated in the same manner as above. The results are shown in Table 1.

### Comparative Example 2

A laminate film was produced in the same manner as in Example 6 except that HMDSN (hexamethyldisilazane), nitrogen and Ar gas were introduced in a ratio by mol of 2/1/1, the film formation pressure was 2.0 Pa and the thickness of the CVD inorganic thin layer was 15 nm. The obtained laminate film was evaluated in the same manner as above. The results are shown in Table 1.

### Comparative Example 3

A laminate film was produced in the same manner as in Comparative Example 2 except that the thickness of the CVD inorganic thin layer was changed to 28 nm at a film formation speed of 50 m/min. The obtained laminate film was evaluated in the same manner as above. The results are shown in Table 1.

### Comparative Example 4

A laminate film was produced in the same manner as in Example 1 except that, not forming a vacuum vapor deposition layer (PVD inorganic thin layer), a three-layered CVD inorganic thin layer (SiOCN) having a total thickness of 10 nm was formed directly on the anchor coat layer by introducing HMDSN (hexamethyldisilazane), nitrogen, oxygen and Ar gas in a ratio by mol of 1/7/14/1 under a film formation pressure of 3.0 Pa and at a film formation speed of 50 m/min followed by plasma CVD treatment repeatedly for a total of three times. The obtained laminate film was evaluated in the same manner as above. The results are shown in Table 1.

**[Table 1]**

| Table 1 | | | | | |
|---|---|---|---|---|---|
| | Layer Configuration | Thickness of CVD Inorganic Thin Layer (nm) | Carbon Content in CVD Inorganic Thin Layer (at.%) | Thickness of PVD Inorganic Thin Layer (nm) | Water Vapor Transmission Rate (g/m²·day) |
| Example 1 | PEN/AC/SiOx(PVD) /SiOCN(CVD)/SiOx (PVD)//CPP | 1 | 2 | 40 | 0.008 |
| Example 2 | PEN/AC/SiOx(PVD) /SiOCN(CVD)/SiOx (PVD)/SiOCN(CVD) /SiOx(PVD)//CPP | 1 | 2 | 40 | 0.005 |
| Example 3 | PEN/AC/SiOx(PVD) /SiOCN(CVD)/SiOC N(CVD)/SiOx(PVD) //CPP | 2 | 3 | 40 | 0.007 |
| Example 4 | PEN/AC/SiOx(PVD) /SiOCN(CVD)/SiOx (PVD)//CPP | 4 | 4 | 40 | 0.010 |
| Example 5 | PEN/AC/SiOx(PVD) /SiOCN(CVD)/SiOx (PVD)//CPP | 8 | 9 | 40 | 0.012 |
| Example 6 | PEN/AC/SiOx(PVD) /SiOCN(CVD)/SiOx (PVD)//CPP | 17 | 15 | 40 | 0.015 |
| Example 7 | PEN/AC/SiOx(PVD) /SiOCN(CVD)/SiOx (PVD)//CPP | 0.1 | 2 | 40 | 0.005 |
| Example 8 | PEN/AC/SiOx(PVD) /SiOCN(CVD)/SiOx (PVD)//CPP | 0.1 | 2 | 25 | 0.005 |
| Comparative Example 1 | PEN/AC/SiOx(PVD) /SiOx(PVD)//CPP | - | 0.0 | 40 | 0.020 |
| Comparative Example 2 | PEN/AC/SiOx(PVD) /SiOCN(CVD)/SiOx (PVD)//CPP | 15 | 25 | 40 | 0.026 |
| Comparative Example 3 | PEN/AC/SiOx(PVD) /SiOCN(CVD)/SiOx (PVD)//CPP | 28 | 30 | 40 | 0.030 |
| Comparative Example 4 | PEN/AC/SiOCN(CVD )/SiOCN(CVD)/SiO CN(CVD)//CPP | 10 | 10 | 40 | 4.6 |

| | | | | | |
|---|---|---|---|---|---|
| * // indicates adhesive layer. | | | | | |

### Industrial Applicability

The gas-barrier laminate film of the present invention is favorably used for wrapping meterials that are required to be shielded from various gases such as water vapor, oxygen and others, for example, for wrapping materials for foods, medicines and others, for materials for solar cells, electronic papers and others, and for packaging materials for electronic devices and others. The gas-barrier laminate film of the present invention shows industrial-scale production at good productivity.

## Claims

1. A gas-barrier laminate film having, on at least one surface of the substrate film thereof, an inorganic thin layer formed by a vacuum vapor deposition, an inorganic thin layer formed by a chemical vapor deposition, and an inorganic thin layer formed by a vacuum vapor deposition in that order thereon, wherein the thickness of the inorganic thin layer formed by vacuum vapor deposition is from 0.1 nm to 500 nm, and the carbon content in the inorganic thin layer formed by chemical vapor deposition is from 0.5 at% to less than 20 at%, and the thickness of the inorganic thin layer is less than 20 nm.

2. The gas-barrier laminate film according to claim 1, wherein the chemical vapor deposition is a plasma CVD.

3. The gas-barrier laminate film according to claim 1 or 2, wherein the thickness of the inorganic thin layer formed by chemical vapor deposition is less than 10 nm.

4. The gas-barrier laminate film according to claim 1 or 2, wherein the thickness of the inorganic thin layer formed by chemical vapor deposition is less than 5 nm.

5. The gas-barrier laminate film according to claim 1 or 2, wherein the thickness of the inorganic thin layer formed by chemical vapor deposition is less than 3 nm.

6. The gas-barrier laminate film according to any of claims 1 to 5, wherein the thickness of the inorganic thin layer formed by vacuum vapor deposition is from 10 nm to 500 nm.

7. The gas-barrier laminate film according to any of claims 1 to 6, wherein the thickness of the inorganic thin layer formed by vacuum vapor deposition is from 10 nm to 100 nm.

8. The gas-barrier laminate film according to any of claims 1 to 7, wherein between the inorganic thin layer formed by chemical vapor deposition and the inorganic thin layer formed by vacuum vapor deposition that are adjacent to each other, the ratio of the thickness (thickness of the inorganic thin layer formed by chemical vapor deposition/thickness of the inorganic thin layer formed by vacuum vapor deposition) is from 0.0001 to 0.2.

9. The gas-barrier laminate film according to any of claims 1 to 8, wherein the carbon content in the inorganic thin layer formed by chemical vapor deposition is from 0.5 at.% to less than 10 at.%.

10. The gas-barrier laminate film according to any of claims 1 to 9, wherein the carbon content in the inorganic thin layer formed by chemical vapor deposition is from 0.5 at.% to less than 10 at.%, and the thickness of the inorganic thin layer formed by chemical vapor deposition is less than 10 nm.

11. The gas-barrier laminate film according to any of claims 1 to 10, wherein the carbon content in the inorganic thin layer formed by chemical vapor deposition is from 0.5 at.% to less than 5 at.%.

12. The gas-barrier laminate film according to any of claims 1 to 11, wherein the carbon content in the inorganic thin layer formed by chemical vapor deposition is from 0.5 at.% to less than 5 at.%, and the thickness of the inorganic thin layer formed by chemical vapor deposition is less than 5 nm.

13. The gas-barrier laminate film according to any of claims 1 to 12, wherein the inorganic thin layer formed by chemical vapor deposition comprises two or more layers.

14. The gas-barrier laminate film according to any of claims 1 to 13, wherein at least one layer of the inorganic thin layers formed by vacuum vapor deposition is formed of a silicon oxide.

15. The gas-barrier laminate film according to any of claims 1 to 14, wherein an anchor coat layer is formed on at least one surface of the substrate film.

16. The gas-barrier laminate film according to any of claims 1 to 15, which has, on the inorganic thin layer formed by vacuum vapor deposition on the inorganic thin layer formed by chemical vapor deposition therein, at least one constitutive unit that comprises an inorganic thin layer formed by a chemical vapor deposition and an inorganic thin layer formed by a vacuum vapor deposition in that order thereon.

17. The gas-barrier laminate film according to any of claims 1 to 16, wherein the substrate film is a transparent polymer film.

18. An electronic paper comprising the gas-barrier laminate film of claims 1 to 17.

19. A solar cell protective film comprising the gas-barrier laminate film of claims 1 to 17.

20. A method for producing a gas-barrier laminate film having, on at least one surface of the substrate film thereof, an inorganic thin layer formed by a vacuum vapor deposition, an inorganic thin layer formed by a chemical vapor deposition, and an inorganic thin layer formed by a vacuum vapor deposition in that order thereon, wherein the thickness of the inorganic thin layer formed by vacuum vapor deposition is from 10 nm to 500 nm, the carbon content in the inorganic thin layer formed by chemical vapor deposition is from 0.5 at% to less than 20 at%, and the thickness of the inorganic thin layer formed by chemical vapor deposition is less than 20 nm, and wherein the inorganic thin layer is formed by vacuum vapor deposition under a reduced pressure of from 10⁻⁴ Pa to 10⁻² Pa and the inorganic thin layer is formed by chemical vapor deposition under a reduced pressure of from 10⁻² Pa to 10 Pa, and the substrate film transportation velocity is 100 m/min or more.

21. The method for producing a gas-barrier laminate film according to claim 20, wherein the formation of the inorganic thin layer by vacuum vapor deposition and the formation of the inorganic thin layer by chemical vapor deposition are carried out continuously in one and the same vacuum chamber.

22. The method for producing a gas-barrier laminate film according to claim 20 or 21, wherein the gas-barrier laminate film is any one of claims 1 to 17.
